# EUROPÄISCHE PATENTANMELDUNG

(11) **EP 1 715 351 A1**
(43) Veröffentlichungstag der Anmeldung: **25.10.2006**
(21) Anmeldenummer: 06007170.1
(22) Anmeldetag: 05.04.2006
(51) Int. Cl.: G01R 11/04, G01R 11/24

(54) **Stromzähleranordnung**

(30) Priorität: 20.04.2005 DE 102005018514
(71) Anmelder: ABB PATENT GmbH, 68526 Ladenburg (DE)
(72) Erfinder: Wieland, Ralf, Dipl.-Ing. (FH), 69429 Waldbrunn (DE); Eppe, Klaus-Peter, Dipl.-Ing., 69429 Waldbrunn (DE)
(74) Vertreter: Miller, Toivo

(57) **Zusammenfassung**

Die Erfindung betrifft eine Stromzähleranordnung, mit einem Adapter (10), auf den ein Stromzähler auf- und einsetzbar ist, mit im Inneren des Adapters befindliche Kontaktelemente, mit denen bei der Montage und Demontage der Strom umgeschaltet wird auf den Stromzähler bzw. umgekehrt. Zur Sperrung des Adapters ist auf den Adapter (10) eine Sperrplatte (20) aufsetzbar, deren dem Adapter zugewandte Seite der Bodenseite des Stromzählers gleicht.

## Beschreibung

Die Erfindung betrifft eine Stromzähleranordnung nach dem Oberbegriff des Anspruches 1.

Eine Stromzähleranordnung der eingangs genannten Art ist aus der DE 10 2004 001 453.1 Dort ist ein Adapter dargestellt, der länglich rechteckig ausgebildet ist, wobei an einer Schmalkante Zu- und Abgangsklemmen angeordnet sind. Innerhalb des Adapters befinden sich in Abstand zueinander angeordnete Kontakttulpenpaare, wobei jeweils ein Paar für eine Phase eingesetzt ist. Die Kontakttulpen werden mittels einer Kontaktbrücke überbrückt bzw. voneinander getrennt, wobei die Kontaktbrücke von am Boden des Stromzählers angeordneten Kontaktfahnen betätigt wird. Zur Fixierung des Stromzählers an dem Adapter sind krallenartige Füße vorgesehen, die in den Adapter eingesteckt werden, wobei der Stromzähler senkrecht nach unten verschoben wird.

Aufgabe der Erfindung ist es, eine Stromzähleranordnung der eingangs genannten Art zu schaffen, mit der eine Zugangsspannung des Adapters bewirkt wird.

Diese Aufgabe wird erfindungsgemäß durch die Merkmale des Anspruches 1 gelöst.

Erfindungsgemäß also ist auf den Adapter eine Sperrplatte aufsetzbar, deren dem Adapter zugewandte Seite der Bodenseite des Stromzählers gleicht. Sie besitzt demgemäß krallenartige Füße, wie sie auch der Stromzähler trägt, die in die entsprechenden Aufnahmeöffnungen am Adapter eingefügt werden können. Darüber hinaus besitzt die Sperrplatte auf der Adapterseite den Anschlussfahnen entsprechende Vorsprünge, die in die Ausnehmungen der Kontaktbrücken eingreifen, so dass nach Einsetzen und Verschieben der Sperrplatte der Stromfluss durch den Adapter verhindert ist.

Dabei können Mittel vorgesehen werden, mit denen die Sperrplatte am Adapter plombiert werden kann.

Die Sperrplatte kann auf der Adapter abgewandten Seite ebenso ausgebildet sein wie die Oberfläche des Adapters, so dass ein Stromzähler auf die Sperrplatte aufgesetzt und dort "geparkt" werden kann.

Weitere vorteilhafte Ausgestaltungen und Verbesserungen der Erfindung sind den weiteren Unteransprüchen zu entnehmen.

Anhand der Zeichnung, in der ein Ausführungsbeispiel der Erfindung dargstellt ist, sollen die Erfindung sowie weitere vorteilhafte Ausgestaltungen und Verbesserungen der Erfindung und weitere Vorteile näher erläutert und beschrieben werden.

Es zeigen
- Fig. 1: eine perspektivische Ansicht eines Adapters mit aufgesetzter Sperrplatte,
- Fig. 2: eine perspektivische Ansicht der Sperrplatte von unten und
- Fig. 3: die Anordnung Adapter mit Sperrplatte und Stromzähler.

Es wird nochmals Bezug auf die DE 10 2004 001 453.1. genommen.

Der dort beschriebene Adapter wirkt mit einem Stromzähler zusammen, wobei am Stromzähler Anschlussfahnen und Krallenfüße vorgesehen sind, mit denen der Stromzähler auf den Adapter aufgesetzt und zur Montage und zum Anschließen verschoben wird. Das Aufsetzen erfolgt senkrecht zur oberen Fläche des Adapters und das Verschieben horizontal bzw. parallel dazu, wobei die Krallenfüße hinter Wände im Adapter greifen.

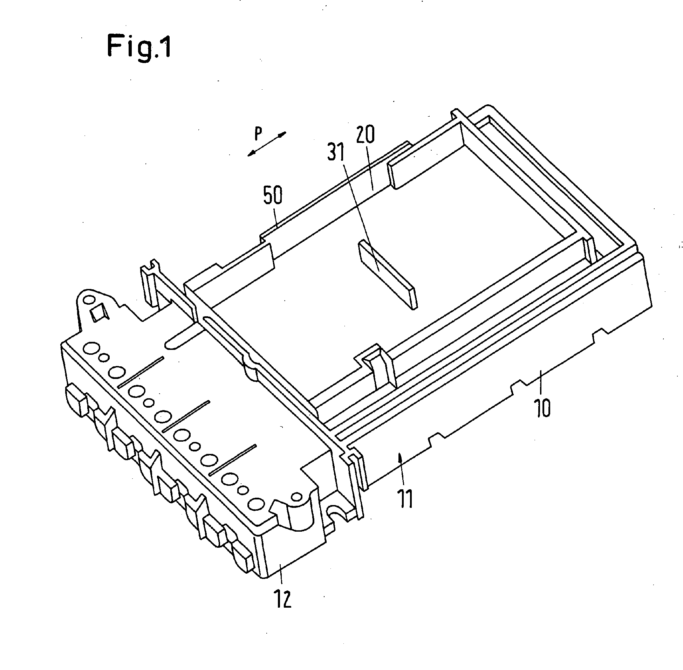

Es sei nun Bezug genommen auf die Fig. 1.

Ein Adapter 10, der den Adapter nach der DE 10 2004. 001 453.1 entspricht, besitzt einen lang gestreckt rechteckigen Körper 11, an dessen einem Ende ein Gehäuseabschnitt 12 angeformt ist, in dem Anschlussklemmen untergebracht sind, an denen Zugangsleitungen vom Energieversorgungsunternehmen und Abgangsleitungen zu den Verbrauchern angeschlossen werden können.

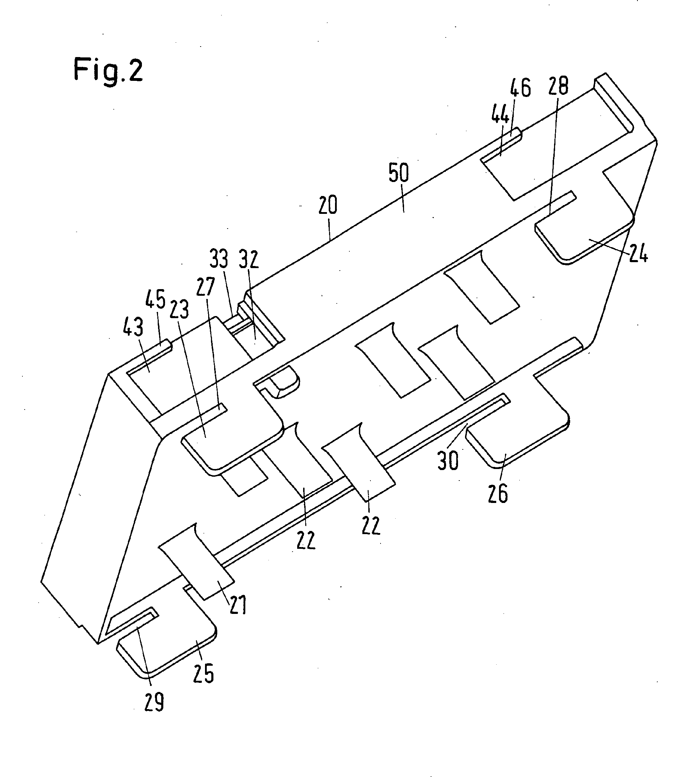

Es sei nun Bezug genommen auf die Fig. 2.

Dort ist in perspektivischer Darstellung eine Sperrplatte 20 gezeigt, die eine Umgangskontur aufweist, die der Umfangskontur eines Stromzählers, siehe DE 10 2004 001 453. 1 entspricht. Auf der dem Betrachter zugewandten Seite der Sperrplatte 20 gemäß Fig. 2 sind fahnenartige Vorsprünge 21, 22 vorgesehen, welche in ihrer Lage, Form und Größe den Anschlussfahnen an der Unterseite des Stromzählers entsprechen. An den Längsseiten, ebenfalls auf der Seite, auf der die Vorsprünge 22, 21 senkrecht dazu vorspringen, sind vier Krallenfüße 23, 24; 25, 26 vorgesehen, die eine L-Form haben, so dass zwischen den Krallenfüßen 23 bis 26 und der Bodenplatte jeweils ein Schlitz 27, 28, 29 und 30 gebildet ist, in welche dann, wenn die Sperrplatte verschoben wird, Wandabschnitte am Adapter eingreifen können.

Damit kann mittels der Sperrplatte 20 durch Einsetzen der Haltefüße bzw. Haltekrallen und der Vorsprünge 21, 22 durch die entsprechenden Öffnungen im Adapter hindurch und durch Verschieben der Platte 20 der Zugang zu den Kontaktstücken innerhalb des Adapters versperrt werden. Zur verbesserten Betätigung der Sperrplatte 20 besitzt diese auf der oberen Fläche, das ist die Fläche, die derjenigen entgegengesetzt liegt, an der die Krallenfüße und die Fahnen vorspringen, einen Handgriff 31, mit dem die Sperrplatte 20 mit der Hand festgehalten werden kann, so dass die Platte einerseits senkrecht zum Adapter und andererseits in Pfeilrichtung P quer dazu bzw. parallel zu seiner Oberfläche verschoben werden kann.

An der Sperrplatte 20 kann sich eine Plombiervorrichtung 32 befinden, die in entsprechender Weise wie die Plombiervorrichtung am Stromzähler arbeitet und in einen entsprechenden Schlitz 33 an der Sperrplatte eingesteckt werden kann.

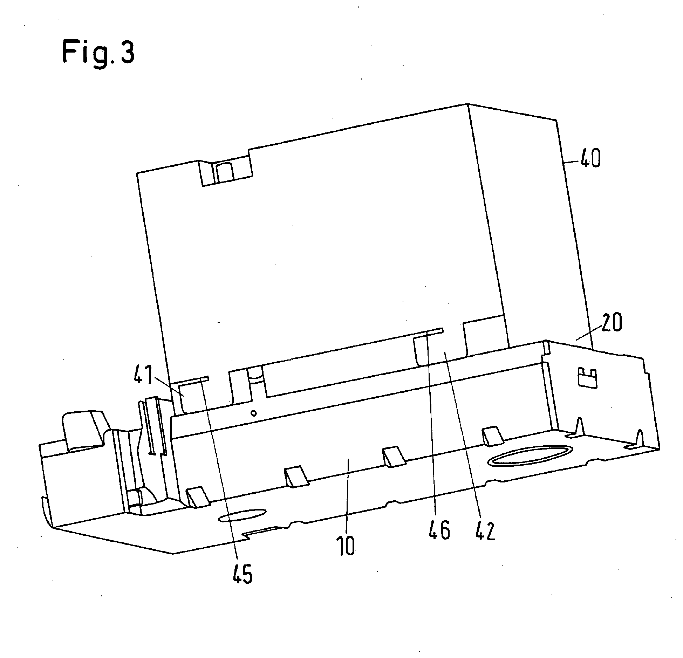

Auf die Sperrplatte 20 kann, wie in Fig. 3 gezeigt, ein Stromzähler 40 aufgesetzt werden. Wie aus der Fig. 3 ersichtlich ist, besitzt der Stromzähler 40 den Haltekrallen 23, 24.... entsprechende Haltekrallen 41 und 42 (die beiden Anderen sind auf der Rückseite nicht zu sehen), die in entsprechende Vertiefungen 43, 44 an der Sperrplatte eingesetzt und in gleicher Weise wieder verschoben werden können. Diese Vertiefungen befinden sich an den Breitseitenflächen und bilden jeweils eine Tasche, die zu der Fläche, auf der sich der Handgriff 31 befindet, mittels einer Leiste 45, 46 teilweise abgedeckt ist; die Leiste 45, 46 hintergreifen dann die Haltekrallen 41 und 42.

Die Sperrplatte wird analog wie der Stromzähler auf den Adapter aufgesetzt und verschoben. Mit der Sperrplatte wird der Adapter gesperrt, wobei im montierten Zustand die innerhalb des Adapters befindlichen Kontakte getrennt und darüber hinaus auch nicht mehr zugänglich sind.

In dieser Lage kann der Stromzähler auf die Sperrplatte positioniert werden, wobei die Sperrplatte plombiert sein kann aber nicht sein muss. Der Stromzähler wird quasi auf der Sperrplatte geparkt.

Nachzutragen ist, dass die Sperrplatte auf der Seite, die dem Adapter entgegengesetzt liegt, eine umlaufende Wandung 50 trägt, deren Höhe so bemessen ist, dass die am Stromzähler befindlichen Anschlußfahnen sich in dem Napfraum innerhalb der umlaufenden Wandung befinden.

## Patentansprüche

1. Stromzähleranordnung, mit einem Adapter, auf den ein Stromzähler auf- und einsetzbar ist, mit im Inneren des Adapters befindliche Kontaktelemente, mit denen bei der Montage und Demontage der Strom umgeschaltet wird auf den Stromzähler bzw. umgekehrt, **dadurch gekennzeichnet, dass** zur Sperrung des Adapters auf den Adapter eine Sperrplatte aufsetzbar ist, deren dem Adapter zugewandte Seite der Bodenseite des Stromzählers gleicht.

2. Stromzähleranordnung nach Anspruch 1, **dadurch gekennzeichnet, dass** Mittel vorgesehen sind, mit denen die Sperrplatte am Adapter plombierbar ist.

3. Stromzähleranordnung nach Anspruch 1 oder 2, **dadurch gekennzeichnet, dass** die Sperrplatte auf der Adapter abgewandten Seite zum Aufsetzen des Stromzählers ausgebildet ist.
